# EUROPEAN PATENT APPLICATION

(11) **EP 0 714 157 A2**
(43) Date of publication of application: **29.05.1996**
(21) Application number: 95308162.7
(22) Date of filing: 14.11.1995
(51) Int. Cl.: H01S 3/025, G02B 6/42

(54) **System and method for removing unstable distortion levels in analog laser packages**

(30) Priority: 23.11.1994 US 344446
(71) Applicant: AT&T Corp., New York, NY 10013-2412 (US)
(72) Inventor: Gaebe, Carl Edward, Fleetwood, Pennsylvania 19522 (US)
(74) Representative: Johnston, Kenneth Graham

(57) **Abstract**

A system and method is disclosed for reducing low level laser feedback from scatter due to particle contamination or defects on optical surfaces. The feedback leads to unstable distortion levels over temperature in analog modulation formats. Feedback is reduced by removing contamination from all unisolated regions of the laser package and by reducing the amount of scattered light reaching the laser. To remove contamination from all unisolated regions of the laser package, an improved cleaning technique is used. To reduce the amount of scattered light reaching the laser, all optical components are placed behind the isolator in the laser package design.

## Description

### Background of the Invention

### 1. Field of the Invention

The present invention relates generally to optical communication systems and more particularly to optical transmission systems using modulated semiconductor injection lasers as optical signal sources.

### 2. Related Art

An analog or digital optical communication system typically uses a semiconductor injection laser whose optical output is modulated by varying the current injected into the laser (current injection modulation) in accordance with a modulating signal which represents information to be transmitted. The output is then transmitted over a transmission line, typically an optical fiber, to a receiver where the modulating signal is detected and the information is recovered and utilized. Such a system may be used, for example, in cable TV, satellite communication and radar communication.

In order to make economical use of such a system, many different signals are simultaneously transmitted (multiplexed) over the same transmission line using the same laser. For this purpose, the laser typically is modulated by a plurality of subcarrier frequencies (frequency multiplexing) which are themselves either amplitude or frequency modulated (AM or FM) by a corresponding plurality of signals. The laser emits these modulated signals in the form of an optical beam which enters a series of optical components designed to focus the optical beam into an optical fiber for transmission to a receiver. However, often times, the surfaces of the optical components contain contaminants or defects which scatter portions of the optical beam back into the laser.

The portion of the optical beam scattered back into the laser functions as feedback to the laser. Depending on the phase of the feedback, the output power of the laser will differ from its intrinsic level (i.e., that power which would have resulted in the absence of such feedback). The phase of the feedback, however, depends on an instantaneous wavelength of the laser and a round-trip optical path length between the laser and the component causing the scatter (hereinafter scattering source). Since the instantaneous wavelength of the laser in turn depends on an instantaneous injection current, the phase of the feedback is modulated along with the injection current. Therefore, the optical response of the laser with respect to the modulation current in the presence of such feedback is different from its intrinsic response. In other words, distortion levels of the laser are altered in the presence of feedback from scattering sources.

Moreover, the phase modulation of the feedback resulting from the current modulation of the laser tends to be much less than one complete cycle whenever the scattering source is very close to the laser chip (as it would be for surfaces present within the laser package itself). The phase of the feedback is then comprised of two parts: a constant or average portion and a modulated portion (the modulated portion being an artifact of the modulation of the injection current).

The constant or average phase depends on the average wavelength of the laser and the optical path length between the laser chip and the scattering source. If the DC portion of the feedback phase is stable, the overall distortion levels in the optical signal emitted from the package will also be stable (although these may be different from the intrinsic levels). If, however, the DC phase of the feedback is variable, then the overall distortion levels in the package will be unstable.

Since the average wavelength of the laser depends on both the DC bias current and the laser chip temperature, the distortion levels in a package where feedback is present will be unstable with respect to laser chip temperature and bias level. Also, since the optical path length can change if the package mechanical dimensions change, the distortion levels can also change in response to mechanical or thermal stresses in the package itself.

What is needed is a system and method for reducing the amount of scattered light fedback to the laser.

### Summary of the Invention

The present invention is directed to a system for reducing low level laser feedback from scatter due to particle contamination or defects on optical surfaces. This feedback leads to unstable distortion levels over temperature in analog modulation formats. According to the invention, two steps are taken to reduce the unstable distortion levels due to feedback caused by contamination. The first step is to remove contamination from all unisolated regions of the laser package. This is accomplished by an improved cleaning technique. The second step is to reduce the amount of feedback produced by scattering. This is accomplished by placing all optical components behind the isolator (i.e., down stream from the laser in the optical path) in the laser package design.

Further features and advantages of the present invention, as well as the structure and operation of various embodiments of the present invention, are described in detail below with reference to the accompanying drawings.

### Brief Description of the Drawings

The present invention is described with reference to the accompanying drawings. In the drawings, like reference numbers indicate identical or functionally similar elements. Additionally, the left-most digit(s) of a reference number identifies the drawing in which the reference number first appears.

FIG. 1 illustrates an optical configuration used in optical communication systems with the isolator outside the laser package.

FIG. 2 illustrates an optical configuration used in optical communication systems with the isolator inside the laser package.

FIG. 3 illustrates an optical configuration designed to reduce unstable distortion levels caused by contaminant scattering.

FIG. 4 is a flow diagram illustrating the method of cleaning optical components in the preferred embodiment.

### Detailed Description of the Embodiments

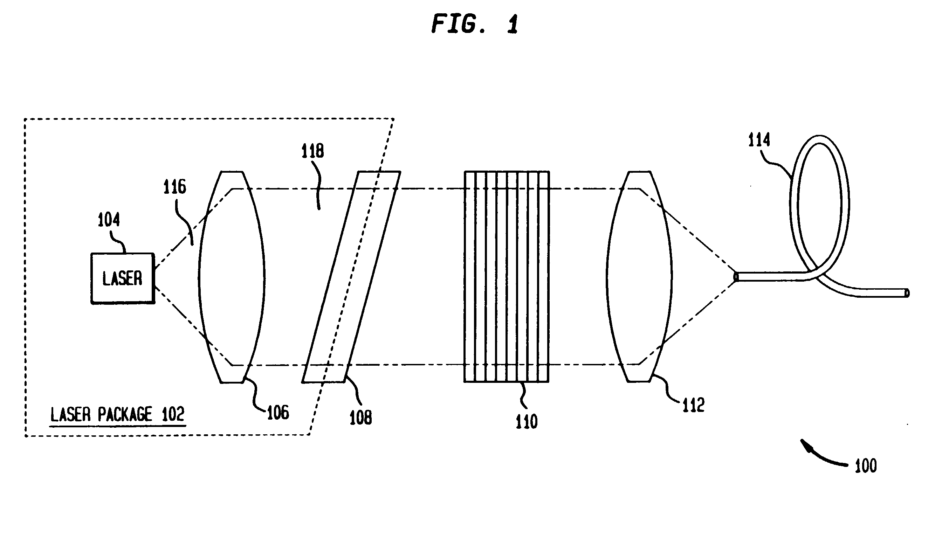

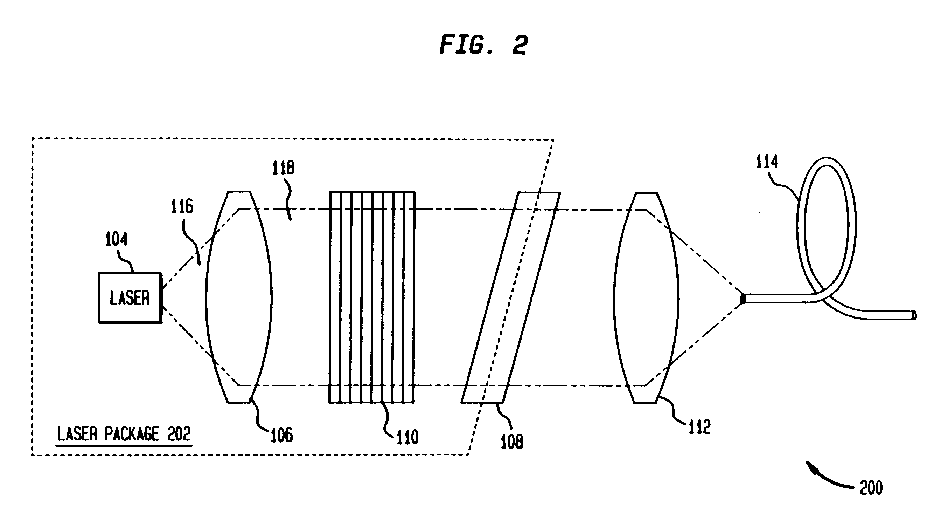

FIG. 1 and FIG. 2 illustrate laser packages and optical configurations typically used in optical communication systems. A configuration 100 in FIG. 1 will be described first. A laser 104 emits a modulated optical beam 116 which is modulated in accordance with analog amplitude or frequency modulation signals as known in the art. In the preferred embodiment, laser 104 is an InGaAsP (indium gallium arsenide phosphide) semiconductor injection laser. According to the present invention, modulated optical beam 116 passes through lens 106 and emerges as collimated beam 118. Collimated beam 118 passes through window 108 and exits laser package 102.

For purposes of this discussion, it is necessary to define certain terms indicating relative positioning of optical components. Terms such as "behind", "in front of", "before", or "after" are used as relative positions from the perspective of laser 104. Thus, in FIG. 1, window 108 is "behind" or "after" lens 106 with respect to laser 104. Similarly, window 108 is "in front of" or "before" isolator 110. Also, the terms "inside" and "outside" reference the boundary of laser package 102 formed by window 108. "Inside" laser package 102 refers to an inclusive region between laser 104 and window 108. "Outside" refers to that region after window 108. Thus, in Fig. 1, laser 104, lens 106 and window 108 are "inside" laser package 102, while isolator 110, lens 112, and optical fiber 114 are "outside" laser package 102. This convention will be followed through out the remaining discussion.

The first optical component outside laser package 102 in configuration 100 is isolator 110. Isolator 110 is a device which allows light to pass in one direction but not the other. Thus, isolator 110 is used to prevent light from reentering laser package 102 as a result of reflection, scattering, etc., from components behind it in the optical path.

Lens 112 collects collimated beam 118 and focuses it into optical fiber 114. Optical fiber 114 then transmits the optical information to other optical communication devices (not shown). A person skilled in the relevant art will recognize that lens 112 is optional in an optical communication system. For example, lens 106 can be designed not to collimate modulated optical beam 116, but rather to focus it directly into optical fiber 114. In this embodiment, modulated optical beam 116 would still pass through window 108 and isolator 110 on its way to entering optical fiber 114.

FIG. 2 contains an optical configuration 200 which is also commonly used in optical communication systems. The only difference between configuration 100 and configuration 200 is that isolator 110 is brought inside a laser package 202 and placed after lens 106 and before window 108. Functionally, configuration 100 and configuration 200 are the same.

As mentioned above, both configuration 100 and configuration 200 are susceptible to light being fedback to laser 104 resulting in unstable distortion levels in modulated optical beam 116 produced by laser 104. This feedback is due to contamination or defects in and on the surfaces of lens 106 and window 108, as well as the surfaces of isolator 110. Particle contaminants (e.g. dust) as small as 50 micrometers in diameter can cause detectable levels of distortion instability. Thus, the cleanliness of the surfaces of the optical components in front of isolator 110 is critical to improving distortion stability by reducing the number of scattering contaminants per surface. Additionally, fewer optical components in front of isolator 110 also reduces distortion instabilities by reducing the number of surfaces capable of scattering light back to laser 104.

Typically, laser packages are assembled in clean rooms with clean components and are then hermetically sealed. However, such laser packages still contain optical components with surfaces sufficiently contaminated to cause significant instability in the levels of distortion in modulated laser signals. One step taken in the preferred embodiment to reduce the distortion instability caused by contaminant scattering is to clean the optical components inside laser package 302 using an improved cleaning technique. This improved technique dramatically reduces the number of contaminants on the surfaces of the optical components.

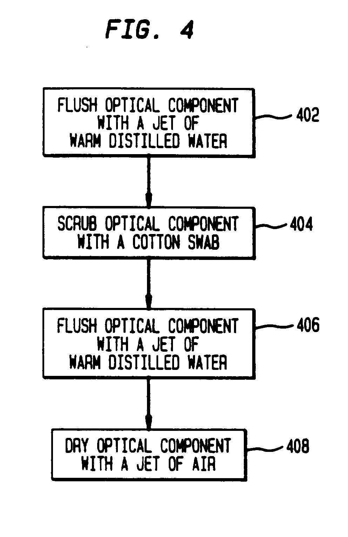

The improved cleaning technique of the present invention is shown as a flow diagram in FIG. 4. First, in a step 402, the surfaces of the optical component are flushed with a jet of warm distilled water. According to the preferred embodiment, warm distilled water produces better results than cold distilled water or most typical solvents. Furthermore, a jet of water produces better results than a water bath. Next, in a step 404, the surfaces are scrubbed with a cotton swab. According to the preferred embodiment, continuing to flush the surfaces with the jet of warm distilled water while the surfaces are scrubbed produces the best results. In a step 406, the surfaces are flushed again with the jet of warm distilled water to remove any remaining contaminants. Finally, in a step 408, the surfaces are dried with a jet of filtered air.

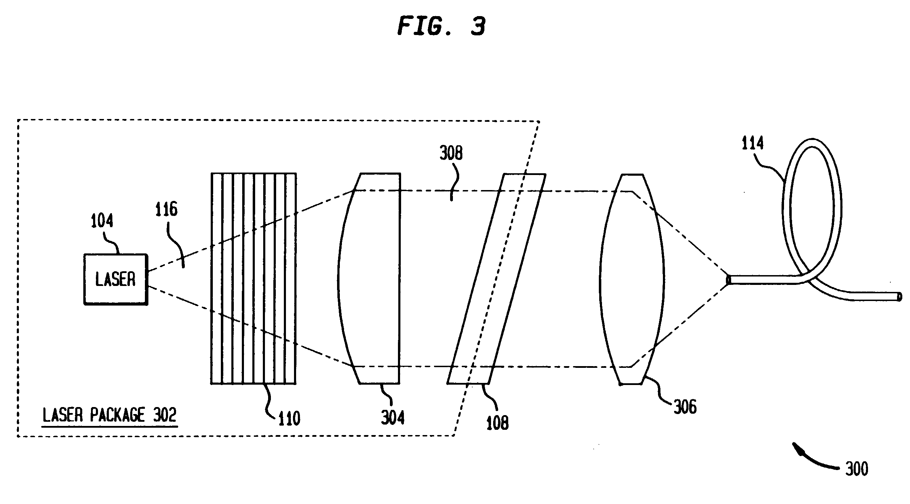

The second step taken in the preferred embodiment to reduce the distortion instabilities caused by contaminant scattering is to place all optical components behind isolator 110 inside laser package 302 as shown in FIG. 3. Again, laser 104 emits a modulated optical beam 116 which is modulated in accordance with analog amplitude or frequency modulation signals. In the preferred embodiment, modulated optical beam 116 passes immediately through isolator 110. Thus, in configuration 300, only the surfaces of isolator 110 potentially contain contaminants which could scatter light back to laser 104.

Typically, isolators have three or more components resulting in at least six surfaces that could scatter light back to a laser. The isolator typically includes a Faraday rotator component. Only those surfaces before the Faraday rotator component will scatter light back to the laser. Typically, an isolator has three such surfaces capable of scattering light back to the laser. Thus, configuration 200 has a total of five surfaces capable of scattering light to laser 104: two surfaces from lens 106 and three surfaces from isolator 110. Configuration 100 has a total of seven surfaces capable of scattering light to laser 104: two surfaces from lens 106, two surfaces from window 108, and three surfaces from isolator 110. In contrast, configuration 300 only has the three surfaces from isolator 110 capable of scattering light to back to laser 104.

After passing through isolator 110, modulated optical beam 116 passes through lens 204. Referring to FIG. 1 and FIG. 3, lens 204 may differ from lens 106 in that lens 204 may correct for any spherical aberration produced by isolator 110. The primary reason optical systems place lens 106 before isolator 110 is to prevent spherical aberration from being introduced into the optical signal. Lens 106 placed close to laser 104 in FIG. 1 significantly reduces spherical aberration because the majority of light passes through the center of lens 106 where its focal point is nearly uniform. In contrast, lens 106 placed after isolator 110 (not shown) collects light across its entire diameter including the outer edges where its focal point tends to vary. This variance in focal point produces the effect known as spherical aberration.

According to the preferred embodiment, isolator 110 is placed immediately after laser 104 to substantially reduce the amount of scattered light reentering laser 104. Thus, in the preferred embodiment, corrective lenses such as lens 304 are used behind isolator 110 to remove the effects of spherical aberration. Alternate embodiments, though, may use a different lens, such as lens 106, in place of lens 304, and handle the problem of spherical aberration differently or not at all.

Referring to FIG. 3, modulated beam 116 passes through lens 304 and exits as collimated beam 308. Collimated beam 308 passes through window 108 and exits laser package 302. Lens 306 collects collimated beam 308 and focuses it onto optical fiber 114 for transmission. Because collimated beam 308 may contain effects of spherical aberration produced by isolator 110 (or any other optical component), lens 306 may also be used to correct for spherical aberration. Thus, in one embodiment, lens 306 is used to correct for spherical aberration in addition to focusing collimated beam 308 onto optical fiber 114. In another embodiment, lens 306 is only used to focus collimated beam 308 onto optical fiber 114. In yet another embodiment, as mentioned previously with respect to lens 112, lens 306 is an optional component and may be eliminated.

Although the invention has been described in detail in terms of specific embodiments, various modifications can be made without departing from the scope of the invention. For example, a different laser device could be utilized as a signal source. Furthermore, a use of the present invention other than for analog optical communications could be realized.

## Claims

1. A laser assembly comprising:
(a) a laser;
(b) a lens disposed adjacent to and in an optical path of said laser;
(c) an optical isolator disposed between said laser and said lens; and
(d) a housing enclosing said laser, said lens and said isolator, said housing having a window in said optical path.

2. The laser assembly in claim 1, wherein said laser is a modulated semiconductor injection laser.

3. The laser assembly in claim 2, wherein said semiconductor injection laser is a InGaAsP laser.

4. A method for reducing feedback due to scattered light in a laser assembly comprised of a laser, a lens, and a housing having a window and enclosing said laser, and said lens, said method comprising locating an optical isolator between said laser and said lens in an optical path of said laser.

5. The method of claim 4 further comprising a step of: cleaning said lens, said isolator, and said window.

6. The method of claim 5, wherein said cleaning comprises the steps of:
flushing said lens, said isolator, and said window with a jet of warm distilled water;
scrubbing said lens, said isolator, and said window with a cotton swab;
flushing said lens, said isolator, and said window a second time with a jet of warm distilled water; and
drying said lens, said isolator, and said window with a jet of filtered air.
